Europäisches Patentamt

European Patent Office

Office européen des brevets

(19)

(11) Veröffentlichungsnummer : **0 198 184**
**B1**

(12) **EUROPÄISCHE PATENTSCHRIFT**

(45) Veröffentlichungstag der Patentschrift :
01.02.89

(51) Int. Cl.⁴ : **H 05 K 5/06**

(21) Anmeldenummer : **86102318.2**

(22) Anmeldetag : **22.02.86**

(54) Entwässerungskanal.

(30) Priorität : **16.04.85 DE 3513537**

(43) Veröffentlichungstag der Anmeldung :
**22.10.86 Patentblatt 86/43**

(45) Bekanntmachung des Hinweises auf die Patenterteilung : **01.02.89 Patentblatt 89/05**

(84) Benannte Vertragsstaaten :
**AT BE CH DE FR GB IT LI LU NL SE**

(56) Entgegenhaltungen :
**WO--A--84 /010 82**
**DE--A-- 2 902 169**
**US--A-- 2 582 031**

(73) Patentinhaber : **Asea Brown Boveri Aktiengesellschaft**
**Kallstadter Strasse 1**
**D-6800 Mannheim-Käfertal (DE)**

(72) Erfinder : **Schwarz, Gerhard, Dipl.-Ing.**
**Zollerwaldstrasse 9**
**D-6936 Allemühl (DE)**
Erfinder : **Eckhard, Herbert**
**Beckstrasse 10**
**D-6930 Eberbach (DE)**

(74) Vertreter : **Kempe, Wolfgang, Dr. et al**
**c/o BROWN, BOVERI & CIE AG ZPT Postfach 351**
**D-6800 Mannheim 31 (DE)**

**Beschreibung**

Die Erfindung betrifft einen Entwässerungskanal gemäß dem Oberbegriff des Anspruches 1.

Bei Gehäusen zur Aufnahme elektrischer Bauelemente besteht oft das Problem, daß sich innerhalb der Gehäuse Kondenswasser bildet, das nach außen abgeführt werden muß. Bei manchen derartigen Gehäusen werden Belüftungsstutzen vorgesehen, die für einen Luftstrom im Inneren des Gehäuses sorgen ; dies hat allerdings den Nachteil, daß ins Innere des Gehäuses Staub eindringen kann. Es ist bekanntgeworden, in Belüftungsstutzen ein poröses Sintermetall einzusetzen, das zur Abdichtung gegen Staub dient und durch das ggf. auch das Kondenswasser ausfließen kann.

Aufgabe der Erfindung ist es, einen Entwässerungskanal der eingangs genannten Art zu schaffen, bei dem eine optimale Abführung des Kondenswassers erzielt wird und bei dem ferner eine Staubdichtigkeit bewirkt wird, und zwar für Schutzart DIN 40050-IP 54 bzw. IP 65.

Diese Aufgabe wird erfindungsgemäß durch die kennzeichnenden Merkmale des Anspruches 1 gelöst.

Ein derartiger Entwässerungskanal läßt das Kondenswasser austreten und aufgrund der syphonartigen Form mit dem Rückschlagventil können Staube und dergleichen nicht ins Innere des Gehäuses gelangen.

Eine bevorzugte Ausführung der Erfindung kann dahingehen, daß der Entwässerungskanal innerhalb eines Kanalgehäuses untergebracht ist, daß an einer Auslaßöffnung am zu entwässernden Gehäuse anschließend befestigbar ist. Zweckmäßigerweise besitzt der Entwässerungskanal einen U-förmigen Kanalabschnitt, dessen erster Schenkel an die Auslaßöffnung mündet und dessen anderer Schenkel erweitert ist, und zur Bildung des Rückschlagventils eine auf Flüssigkeit aufschwimmende Kugel enthält ; der U-Bogen dieses Kanalabschnittes bildet dann die tiefste Stelle des syphonartigen Entwässerungskanals.

Damit das Wasser auch abfließen kann, ist in den zweiten Schenkel ein parallel zum ersten Schenkel und in entgegengesetzte Richtung wie dieser — nach unten offen — weisender Abflußkanal eingeführt, wodurch der Entwässerungskanal mit Rückschlagventil gebildet wird.

Dabei gibt es zwei Ausführungsmöglichkeiten ; gemäß kennzeichnenden Merkmalen des Anspruches 4 ist das Kanalgehäuse aus zwei spiegelbildlich symmetrischen Gehäusehälften gebildet, die gemäß kennzeichnenden Merkmalen des Anspruches 5 mit Zapfen und Vertiefungen miteinander verbunden werden können ; zur Befestigung dieses Kanalgehäuses sind Zapfen vorgesehen, die entweder an dem Gehäuse zur Aufnahme der elektrischen Bauelemente anschnappbar oder hinter einen Gewindering schnappbar sind, der selbst zur Befestigung des Kanalgehäuses am Gehäuse zur Aufnahme der elektrischen Bauteile bzw. Bauelemente dient.

Eine weitere Ausgestaltung ist im kennzeichnenden Merkmal des Anspruches 8 zu entnehmen ; gemäß kennzeichnenden Merkmalen des Anspruches 10 sind zwei Gehäuseteile vorgesehen, die miteinander verschraubt sind.

Die Kugel ist vorzugsweise als Hohlkugel aus zwei hohlen Halbkugeln zusammengesetzt, so daß sie auf der Flüssigkeit im Inneren des Syphons aufschwimmen kann.

Weitere vorteilhafte Ausgestaltungen der Erfindung sind den weiteren Unteransprüchen zu entnehmen. Mit der erfindungsgemäßen Ausführung wird eine optimale Entwässerung erreicht, die auch den Forderungen nach Dichtigkeit gemäß Schutzart DIN 40050-IP 54 und IP 65 entspricht.

Anhand der Zeichnung, in der zwei Ausführungsbeispiele der Erfindung dargestellt sind, soll die Erfindung näher erläutert und beschrieben werden.

Es zeigt :

Fig. 1 eine Ansicht eines Gehäuseteiles gemäß einer ersten Ausführungsform,

Fig. 2 eine Schnittansicht gemäß der Schnittlinie II-II der Fig. 1,

Fig. 3 eine Schnittansicht gemäß der Schnittlinie III-III der Fig. 2,

Fig. 4 eine Schnittansicht einer weiteren Ausführungsform der Erfindung gemäß Schnittlinie IV-IV und

Fig. 5 eine Schnittansicht gemäß der Schnittlinie V-V der Fig. 4.

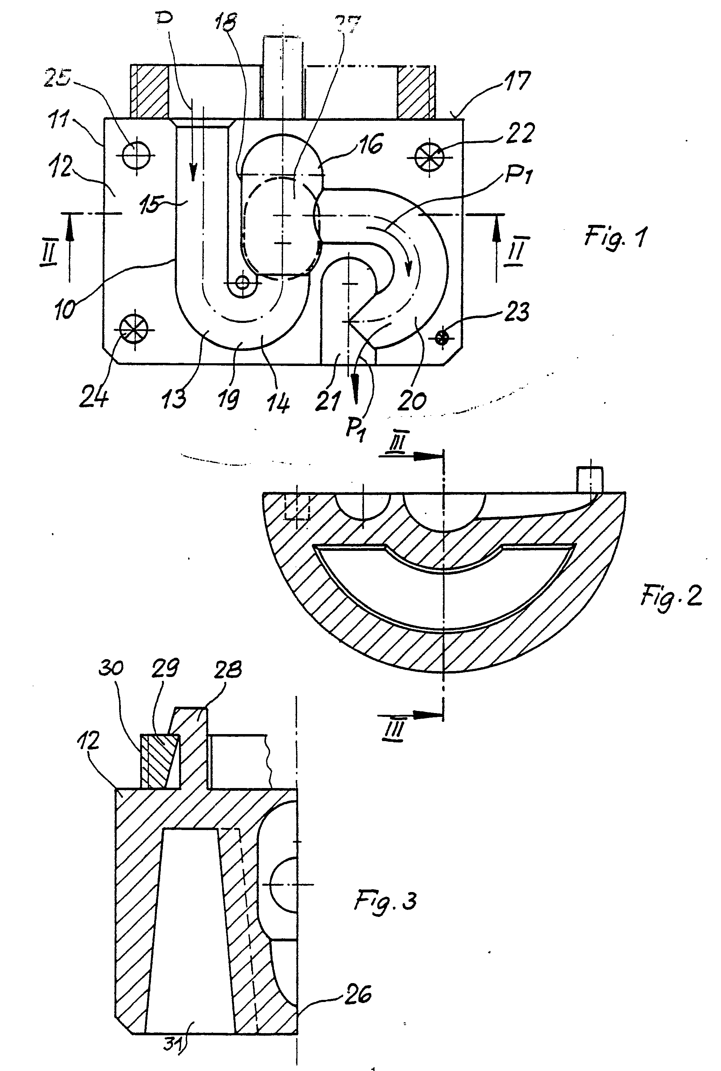

Es sei nun bezug genommen auf die Figur 1. Ein Entwässerungskanal 10 ist in einem Kanalgehäuse 11 gebildet, von dem die Figur 1 nur ein Gehäuseteil 12 zeigt. Man blickt dabei auf diejenige Seitenfläche, in der eine im Querschnitt halbkreisförmige Vertiefung 13 eingebracht ist, die einen ersten, U-förmigen Abschnitt 14 aufweist, dessen erster Schenkel 15 zu einer nicht näher dargestellten Auslaßöffnung an einem Gehäuse hingerichtet ist und mit dieser fluchtet. Der U-förmige Abschnitt besitzt ferner einen zweiten Schenkel 1b, der zu jener Fläche 17 des Kanalgehäuses hin abgeschlossen ist und der eine Erweiterung 18 aufweist, dessen Aufgabe weiter unten dargestellt ist. Der Bogen 19 des U-förmigen Abschnittes ist im montierten Zustand an dem Gehäuse die tiefste Stelle.

Quer zu dem zweiten Schenkel, also quer zur Erweiterung 18 verläuft ein U-förmig gekrümmter Auslaßkanal 20, der in eine Sacklochbohrung 21 einmündet die zu derjenigen Seite hin, die der Seite 17 gegenüberliegt, offen ist. Auf der in Figur 1 sichtbaren Fläche, das die Teilfläche des Kanalgehäuses 11 darstellt, sind Zapfen 22 und 23 und 24 vorgesehen, sowie eine Bohrung 25, die mit Bohrungen an der spiegelbildlich symmetrischen Gehäusehälfte bzw. Zapfen zusammenwirken, wobei durch Pressitz eine Verbindung der beiden Gehäusehälften bewirkt wird. Die Gehäusehälfte 12 der Figur 3 wird damit durch eine nicht dargestellte spiegelsymmetrische Gehäusehälfte ergänzt, die an die Berührungsfläche 26 angesetzt wird, wodurch die Vertiefungen 13 sich zu dem Entwässerungskanal 10 ergänzen. Im Inneren der Erweiterung 18 befindet sich eine Hohlkugel 27, die in der Erweiterung 18 frei beweglich ist.

An der Fläche 17 des Gehäuses 11 sind Schnapphaken 28 angeformt, die hinter einen Befestigungsring 29 greifen bzw. von diesem umfaßt werden, an dessen Außenrand ein Außengewinde 30 angeformt ist, mit dem das Kanalgehäuse 11 an dem zu entwässernden Gehäuse befestigt werden kann. Vertiefungen 31 dienen der Gewichtsersparnis.

Wenn sich im Inneren des Gehäuses Kondenswasser bildet, dann läuft dieses Kondenswasser in Pfeilrichtung P in die tiefste Stelle, nämlich in den U-Bogen hinein und zwar soweit, bis die aufgrund der Schwerkraft auf dem untersten Bereich der Erweiterung 18 aufliegende Kugel 27 aufschwimmt; je mehr Wasser in den Kanal hineinläuft, desto weiter steigt der Wasserspiegel darin und zwar soweit, bis der Wasserspiegel die obere Kante des Auslaßkanales 20 erreicht, wenn dies der Fall ist, kann das Wasser aus dem Auslaßkanal 20 und die Sacklochbohrung 21 gemäß Pfeilrichtung P1 abströmen. Wenn umgekehrt durch die Sacklochbohrung 21 Wasser oder Staub oder ähnliches eindringen würde, dann würde die Hohlkugel 27 gegen den unteren Bereich der Erweiterung 18 gedrückt, wodurch diese in jenem Bereich abgedichtet wird, so daß eine Rückströmung entgegen der Richtung P nicht möglich ist. Daß das Entwässerungsgehäuse 11 grundsätzlich an der tiefsten Stelle des die elektrischen Bauteile aufnehmenden Gehäuses angeordnet ist, ist selbstverständlich.

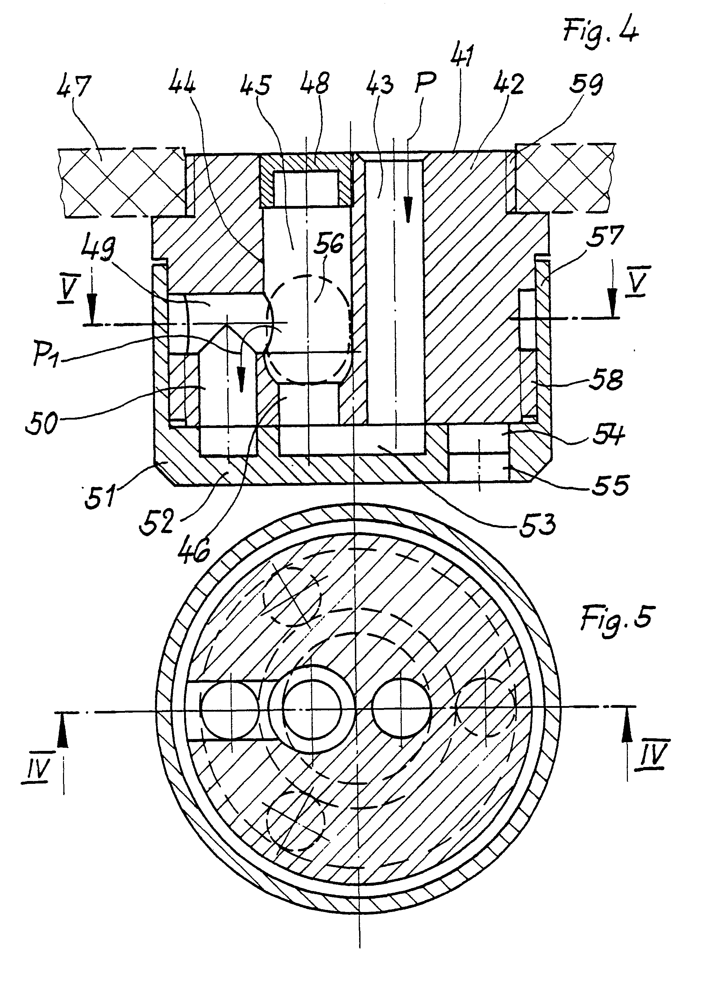

Die Figuren 4 und 5 zeigen eine andere Ausführungsform der Erfindung. Das Kanalgehäuse 41 besitzt ein erstes Gehäuseteil 42, das einen kreiszylinderförmigen Querschnitt aufweist. Das erste Gehäuseteil 42 ist von einer ersten Bohrung 43, auch Durchgangsbohrung 43 genannt, durchbrochen und parallel dazu verläuft eine zweite Bohrung 44, die einen erweiterten Abschnitt 45 aufweist, der sich nach unten hin in den Bereich 46 verengt. Nach oben hin, also auf der dem Gehäuse 47 zugewandten Seite ist die zweite Bohrung 44 mittels eines Stopfens 48 verschlossen. In die Erweiterung 45 mündet eine Querbohrung 49, an der selbst wiederum eine Auslaßbohrung bzw. Auslaßkanal 50 anschließt. Das Kanalgehäuse 41 besitzt ferner ein zweites Gehäuseteil 51, das napfartig ausgebildet ist; in dessen Topf- bzw. Napfboden 52 und zwar auf dessen Innenseite ist eine kreisförmige Vertiefung 53 eingebracht in die die Verengung 46 und die Bohrung 43 einmünden. Diese kreisförmige Vertiefung ist von einem Kanalring 54 umgeben, in den der Auslaßkanal 50 einmündet. In den Kanalring 54 münden mehrere Durchgangsbohrungen 55 ein, vorzugsweise drei, die gleichmäßig am Umfang verteilt sind.

Im Inneren der Erweiterung 45 befindet sich eine Kugel 56, die wieder als Rückschlagventil für den Austritt des Wassers dient. Der Rand 57 des zweiten Gehäuseteiles überdeckt die Querbohrung 49 und dichtet diese nach außen hin ab. Die Verbindung der beiden Gehäuseteile miteinander erfolgt mittels einer Gewindeverbindung 58.

Wenn aus dem Gehäuse 47 Kondenswasser austritt, strömt dieses gemäß Pfeilrichtung P in die Durchgangsbohrung 43 hinein und gelangt so in die Verengung 46 bzw. Erweiterung 45, in der dann die Kugel 56 aufschwimmt. Der Wasserspiegel steigt dort so lange, bis die untere Kante der Querbohrung 49 erreicht ist; danach kann das Wasser P1 ab und durch die Bohrungen 55 nach außen wegfließen.

Die Befestigung des Gehäuses 41 erfolgt mittels einer Schraubbefestigung. Zu diesem Zwecke besitzt das Gehäuse 41 einen Gewindeabschnitt 59 mit dem das Gehäuse 41 in das Gehäuse 47 eingeschraubt werden kann.

Die Ausführung gemäß den Figuren 4 und 5 ist gegenüber der Ausführung gemäß den Figuren 1 bis 3 insoweit günstiger, als bei der Ausführung gemäß den Figuren 1 bis 3 ein Einfrieren des im U-Bogen befindlichen Wassers zu einer Beschädigung bzw. Zerstörung des Gehäuses führen kann. Bei der Ausführung gemäß den Figuren 4 und 5 sind diese Nachteile im wesentlichen vermieden. Es wird dann lediglich bewirkt, daß sich der Boden 52 des zweiten Gehäuseteiles 51 nach unten ausbiegt. Eine Beschädigung und Zerstörung ist dadurch nicht gegeben.

**Patentansprüche**

1. Aus einem Gehäuse zur Aufnahme elektrischer Bauelemente herausgeführter Entwässerungskanal, dadurch gekennzeichnet, daß der Entwässerungskanal (10) syphonartig ausgebildet ist und daß innerhalb des Entwässerungskanals ein Rückschlagventil (16, 56) vorgesehen ist, das ein Austreten von Flüssigkeit aus dem Gehäuse gestattet, ein Eindringen von Flüssigkeit und/oder Staub dagegen hindert.

2. Entwässerungskanal nach Anspruch 1, dadurch gekennzeichnet, daß der Entwässerungskanal (10) innerhalb eines Kanalgehäuses (11, 41) untergebracht ist, das an einer Auslaßöffnung aus dem zu entwässernden Gehäuse anschließend befestigbar ist.

3. Entwässerungskanal nach einem der vorigen Ansprüche, dadurch gekennzeichnet, daß der Entwässerungskanal (10) einen U-förmigen Kanalabschnitt aufweist, dessen einer Schenkel an die Auslaßöffnung mündet und dessen anderer Schenkel erweitert ist und zur Bildung des Rückschlagventils eine auf Flüssigkeit aufschwimmende Kugel (27, 56) enthält und dessen U-Bogen die tiefste Stelle des syphonartigen Entwässerungskanales bildet.

4. Entwässerungskanal nach einem der vorigen Ansprüche, dadurch gekennzeichnet, daß in den zweiten Schenkel eine parallel zum ersten Schenkel und in entgegengesetzter Richtung wie dieser nach unten offen weisender Abflußkanal einmündet.

5. Entwässerungskanal nach einem der vorigen Ansprüche, dadurch gekennzeichnet, daß das Kanalgehäuse aus zwei spiegelbildlich symmetrisch zueinander ausgebildeten und einander angesetzten Gehäusehälften besteht, in deren aufeinander zuweisenden Berührungsfläche je eine der Kanalform entsprechende Vertiefung eingebracht ist, wobei sich beide Vertiefungen in beiden Gehäusehälften im montierten Zustand zu dem Entwässerungskanal ergänzen.

6. Entwässerungskanal nach Anspruch 5, dadurch gekennzeichnet, daß an den Berührungsflächen Zapfen und Vertiefungen vorgesehen sind, die ineinandergreifen und aufeinander zur Bildung eine Klemmsitzes angebracht sind.

7. Entwässerungskanal nach einem der vorigen Ansprüche, dadurch gekennzeichnet, daß zusätzlich an jeder Gehäusehälfte an der der Auslaßöffnung des zu entwässernden Gehäuses benachbarten Seite je ein Schnapphaken angeformt ist, mit dem beide Gehäusehälften an dem Gehäuse festrastbar sind.

8. Entwässerungskanal nach Anspruch 7, dadurch gekennzeichnet, daß die Schnapphaken zusätzlich von einem Gewindering umfaßt und an diesem festgerastet sind, der an das Gehäuse anschraubbar ist.

9. Entwässerungskanal nach einem der Ansprüche 1 bis 4, dadurch gekennzeichnet, daß das Kanalgehäuse ein erstes Gehäuseteil, in dem zwei in Abstand zueinander verlaufende Durchgangsbohrungen vorgesehen sind, von denen die erste der Auslaßöffnung am Gehäuse zugeordnet und in diese einmündend ausgebildet ist und die zweite das Rückschlagventil aufnimmt und zum Gehäuse hin verschlossen ist, und eine mit der zweiten Durchgangsbohrung verbundenen Auslaßbohrung, die zu der dem Gehäuse entgegengesetzen Seite hin offen ist, aufweist, und eine mit dem ersten Gehäuseteil fest verbundenes zweite Gehäuseteil umfaßt, in dem ein Verbindungskanal für die beiden Durchgangsbohrungen auf der der Auslaßöffnung abgewandten Seite eingebracht ist, wodurch der U-förmige Bogen des Entwässerungskanales gebildet ist.

10. Entwässerungskanal nach Anspruch 9, dadurch gekennzeichnet, daß im zweiten Gehäuseteil ein von dem Verbindungskanal flüssigekeitsdicht getrennter Kanalring (54) vorgesehen ist, in den die Auslaßbohrung im ersten Gehäuseteil einmündet und der über Ablaßbohrungen nach außen offen ist.

11. Entwässerungskanal nach Anspruch 9, dadurch gekennzeichnet, daß zur Verbindung der Auslaßbohrung mit der zweiten Durchgangsbohrung eine Querbohrung vorgesehen ist, die von einem Kragen am zweiten Gehäuseteil abgedeckt ist.

12. Entwässerungskanal nach Anspruch 11, dadurch gekennzeichnet, daß beide Gehäuseteile zylinderförmig ausgebildet und miteinander verschraubt sind.

13. Entwässerungskanal nach einem der Ansprüche 10 bis 12, dadurch gekennzeichnet, daß der Verbindungskanal eine kreisförmige Vertiefung und der Kanalring ein die Vertiefung konzentrisch umgebender Kreisring ist.

14. Entwässerungskanal nach einem der vorigen Ansprüche, dadurch gekennzeichnet, daß die Kugel hohl und aus zwei hohlen Halbkugeln zusammengesetzt ist.

## Claims

1. Drainage channel leading out of a housing to accommodate electrical components, characterized in that the drainage channel (10) is of siphon-like construction and that a nonreturn valve (16, 56) which is provided within the drainage channel permits a discharge of liquid from the housing, but prevents a penetration of liquid and/or dust.

2. Drainage channel according to Claim 1, characterized in that the drainage channel (10) is accommodated within a channel housing (11, 41) which is attachable adjacent to an outlet aperture from the housing to be drained.

3. Drainage channel according to one of the preceding claims, characterized in that the drainage channel (10) exhibits a U-shaped channel section, one member of which leads to the outlet aperture and the other member of which is enlarged and contains a ball (27, 56) which floats on liquid to form the nonreturn valve and the U-bend of which forms the lowest point of the siphon-like drainage channel.

4. Drainage channel according to one of the preceding claims, characterized in that a discharge channel pointing parallel to the first member and in the opposite direction to the latter, open towards the bottom, leads into the second member.

5. Drainage channel according to one of the preceding claims, characterized in that the channel housing consists of two housing halves constructed in mutual mirror-image symmetry and placed together, in the mutually facing contact surface of each of which a recess corresponding to the channel shape is made, whilst the two recesses in the two housing halves complement each other to form the drainage channel in the assembled state.

6. Drainage channel according to Claim 5, characterized in that lugs and recesses are provided on the contact surfaces, engage mutually and are mutually coordinated to form a force fit.

7. Drainage channel according to one of the preceding claims, characterized in that a snap hook, by which the two housing halves can be engaged firmly to the housing is formed additionally on each housing half on the side adjacent to the outlet aperture of the housing to be drained.

8. Drainage channel according to Claim 7, characterized in that the snap hooks are additionally surrounded by a screwthreaded ring and engaged firmly on the latter which is screwable onto the housing.

9. Drainage channel according to one of Claims 1 to 4, characterized in that the channel housing exhibits a first housing part, in which two passage bores extending at a mutual interval (sic), of which the first is associated with the outlet aperture on the housing and constructed to lead into the latter and the second accommodates the nonreturn valve and is closed towards the housing, and an outlet bore connected to the second passage bore, which is open towards the side opposite the housing, and comprises a second housing part connected firmly to the first housing part, in which a connecting channel for the two passage bores is provided on the side remote from the outlet aperture, by which the U-shaped bend of the drainage channel is formed.

10. Drainage channel according to Claim 9, characterized in that a channel ring (54) separated fluid-tightly from the connecting channel, into which the outlet bore in the first housing part leads and which is open to the outside through discharge bores, is provided in the second housing part.

11. Drainage channel according to Claim 9, characterized in that a transverse bore which is masked by a collar on the second housing part is provided to connect the outlet bore to the second passage bore.

12. Drainage channel according to Claim 11, characterized in that the two housing parts are of cylindrical construction and screwed together.

13. Drainage channel according to one of Claims 10 to 12, characterized in that the connecting channel is a circular recess and the channel ring is a circular ring concentrically surrounding the recess.

14. Drainage channel according to one of the preceding claims, characterized in that the ball is hollow and is composed of two hollow hemispheres.

## Revendications

1. Canal de drainage sortant d'un boîtier destiné à recevoir des composants électriques, caractérisé en ce que ledit canal de drainage (10) est réalisé à la manière d'un siphon et qu'à l'intérieur du canal de drainage il est prévu un clapet anti-retour (16, 56) qui permet l'écoulement d'un liquide du boîtier, tout en empêchant la pénétration d'un liquide et/ou de poussière.

2. Canal de drainage selon la revendication 1, caractérisé en ce que le canal de drainage (10) se trouve à l'intérieur d'un boîtier de canal (11, 41) qui peut ensuite être fixé à un orifice d'écoulement du boîtier à drainer.

3. Canal de drainage selon l'une quelconque des revendications précédentes, caractérisé en ce que le canal de drainage (10) possède une portion de canal en forme de U, dont une branche (15) débouche dans l'orifice d'écoulement et l'autre branche (16) est élargie et contient, pour former le clapet anti-retour, une bille (27, 56) flottant sur le liquide, et dont l'arc en U constitue le point le plus bas du canal de drainage en forme de siphon.

4. Canal de drainage selon l'une quelconque des revendications précédentes, caractérisé en ce que dans la deuxième branche (16) débouche un canal d'écoulement (20) ouvert vers le bas, parallèle à la première branche (15) et orienté dans la direction opposée.

5. Canal de drainage selon l'une quelconque des revendications précédentes, caractérisé en ce que le boîtier de canal (11) se compose de deux moitiés de boîtier réalisées de façon symétrique et reliées l'une à l'autre, dans les surfaces de contact tournées l'une vers l'autre desquelles est ménagé un évidement correspondant à la forme du canal, les deux évidements dans les deux moitiés de boîtier se complétant à l'état monté pour former le canal de drainage (10).

6. Canal de drainage selon la revendication 5, caractérisé en ce que sur les surfaces de contact il est prévu des doigts (22, 23, 24) et des creux (25) qui sont en contact les uns avec les autres et emmanchés pour former un ajustement par serrage.

7. Canal de drainage selon l'une quelconque des revendications précédentes, caractérisé en ce qu'en plus un crochet d'encliquetage (28), permettant d'encliqueter les deux moitiés de boîtier sur le boîtier à drainer, est formé sur chaque moitié de boîtier, sur le côté adjacent à l'orifice d'écoulement du boîtier à drainer.

8. Canal de drainage selon la revendication 7, caractérisé en ce que les crochets d'encliquetage (28) sont en plus entourés par une bague filetée (29) pouvant être vissée sur le boîtier et encliquetés sur celle-ci.

9. Canal de drainage selon l'une quelconque des revendications 1 à 4, caractérisé en ce que le boîtier de canal (11) comprend une première partie de boîtier, possédant deux trous de passage s'étendant à distance l'un de l'autre, dont le premier est associé à l'orifice d'écoulement du boîtier et débouche dans celui-ci et le deuxième reçoit le clapet anti-retour et est fermé vers le boîtier, et un trou d'écoulement relié au deuxième trou de passage et ouvert vers le côté opposé au boîtier, ainsi qu'une deuxième partie de boîtier, raccordée de manière fixe à la première partie de boîtier, dans laquelle est ménagé un canal de liaison pour les deux trous de passage sur le côté opposé à l'orifice d'écoulement, ce qui forme l'arc en forme de U du canal de drainage.

10. Canal de drainage selon la revendication 9, caractérisé en ce que dans la deuxième partie de boîtier il est prévu un anneau de canal (54), séparé de manière étanche aux liquides du canal de liaison, dans lequel débouche l'orifice d'écoulement se trouvant dans la première partie de boîtier et qui est ouvert vers l'extérieur par des orifices d'écoulement (55).

11. Canal de drainage selon la revendication 9, caractérisé en ce qu'un trou transversal, qui est recouvert par une collerette sur la deuxième partie de boîtier, est prévu pour la liaison entre le trou d'écoulement et le deuxième trou de passage.

12. Canal de drainage selon la revendication 11, caractérisé en ce que les deux parties de boîtier sont réalisées de façon cylindrique et vissées l'une à l'autre.

13. Canal de drainage selon l'une quelconque des revendications 10 à 12, caractérisé en ce que le canal de liaison est un évidement circulaire et l'anneau de canal est un cercle entourant de manière concentrique ledit évidement.

14. Canal de drainage selon l'une quelconque des revendications précédentes, caractérisé en ce que la bille (27, 56) est creuse et se compose de deux hémisphères creux.

EP 0 198 184 B1

Fig. 1

Fig. 2

Fig. 3

Fig. 4

Fig. 5